Europäisches Patentamt

European Patent Office

Office européen des brevets

(19)

(11) Publication number: **0 447 976 A1**

# EUROPEAN PATENT APPLICATION

(21) Application number: 91104009.5

(22) Date of filing: 15.03.91

(51) Int. Cl.5: **H01L 27/112**

(30) Priority: 16.03.90 JP 64112/90

(43) Date of publication of application:
**25.09.91 Bulletin 91/39**

(84) Designated Contracting States:
**DE FR GB**

(71) Applicant: **KABUSHIKI KAISHA TOSHIBA**
**72, Horikawa-cho Saiwai-ku**
**Kawasaki-shi Kanagawa-ken 210(JP)**

Applicant: **TOSHIBA MICRO-ELECTRONICS**
**CORPORATION**
**25-1, Ekimaehoncho**
**Kawasaki-ku Kawasaki-shi(JP)**

(72) Inventor: **Takase, Shinsuke, c/o Intellectual**
**Property Div.**
**Kabushiki Kaisha Toshiba, 1-1 Shibaura**
**1-chome**
**Minato-ku, Tokyo 105(JP)**
Inventor: **Tanaka, Yutaka, c/o Intellectual**
**Property Div.**
**Kabushiki Kaisha Toshiba, 1-1 Shibaura**
**1-chome**
**Minato-ku, Tokyo 105(JP)**
Inventor: **Hashimoto, Hisashi, c/o Intellectual**
**Property Div.**
**Kabushiki Kaisha Toshiba, 1-1 Shibaura**
**1-chome**
**Minato-ku, Tokyo 105(JP)**

(74) Representative: **Lehn, Werner, Dipl.-Ing. et al**
**Hoffmann, Eitle & Partner Patentanwälte**
**Arabellastrasse 4**
**W-8000 München 81(DE)**

(54) **Read-only semiconductor memory device.**

(57) A source (13), a drain (14), and a channel (15) are formed in an element region of a semiconductor substrate (11). A gate electrode (16) is formed above the channel (15). An insulating oxide film (18) is deposited on the entire surface of the resultant structure. Contact holes (19) and (20) are formed to bring the source (13) and drain (14) of each memory cell transistor into contact with each other. A wiring layer of a first aluminum layer is formed on the insulating oxide film including inner portions of the contact holes (19) and (20). The wiring layer includes a wiring layer (21A) for connecting adjacent memory cell transistors and a wiring layer (21B) for short-circuiting the source (13) and drain (14) to operate a memory cell transistor in the same manner as a depletion type transistor does.

F I G. 1

The present invention relates to a read-only semiconductor memory device using a multi-layer wiring technique and, more particularly, to a semiconductor memory device in which data is programmed in the process of manufacturing the same.

A mask ROM or the like is used as a read-only semiconductor memory device in which data is programmed in the process of manufacturing the same. The following three methods have been conventionally known to program data in a chip of the mask ROM.

(1) In a memory device wherein a plurality of memory cell transistors are constituted of a NAND-connected (series-connected) memory cell transistor group, when channel regions of the memory cell transistors are formed, an amount of ion to be implanted is adjusted to achieve an enhancement-type or depletion-type memory cell transistor, thereby performing data programming.

(2) In a memory device wherein a plurality of memory cell transistors are constituted of a NOR-connected (parallel-connected) memory cell transistor group, data programming depends upon whether or not the memory cell transistors are formed in certain positions.

(3) In a memory device wherein a plurality of memory cell transistors are constituted of a NOR-connected (parallel-connected) memory cell transistor group, data programming depends upon whether a source-side contact hole or a drain-side contact hole is formed or not.

Semiconductor memory devices manufactured by the above methods have the following problems.

In a semiconductor memory device manufactured by the method (1) or (2), a process of programming data, mainly a process of implanting ions is earlier than a process of forming a gate electrode. In other words, data is programmed at the early stage of a chip manufacturing process. It is thus impossible to program data in a semi-finished chip by user's request after receiving an order. It takes a long time to obtain finished products after data to be programmed is determined.

If data is changed after ions are implanted, it cannot be reprogrammed. All semi-finished products must be given up.

In a semiconductor memory device manufactured by the above method (3), since a region for forming a contact hole needs to be formed at the source or drain side of a memory cell transistor, a size in chip is increased. Such a semiconductor memory device is not suitable for high degree of integration.

As described above, in the conventional read-only semiconductor memory device in which data is programmed in the process of manufacturing the same, it is difficult to shorten a period of time during which a user determines data and then obtains a product.

It is accordingly an object of the present invention to provide a read-only semiconductor memory device suitable for high degree of integration, which allows a period of time during which a user determines data and obtains a product to be relatively short.

According to one aspect of the present invention, there is provided a read-only semiconductor memory device comprising: a memory cell group including at least two series-connected memory cells each constituted of a MOS transistor having a source and a drain; and a first wiring layer for short-circuiting a source and a drain of a specific one of the memory cells of the memory cell group in accordance with program data.

According to another aspect of the present invention, there is provided a read-only semiconductor memory device comprising: a semiconductor substrate of a first conductivity type; a plurality of diffusion layers of a second conductivity type, formed in the semiconductor substrate at predetermined intervals; a plurality of gate electrodes each formed so as to extend over adjacent two diffusion layers; an insulating layer formed on said plurality of gate electrodes; and a wiring layer formed of a metal wiring layer formed on said insulating layer, for connecting said adjacent two diffusion layers in accordance with program data.

This invention can be more fully understood from the following detailed description when taken in conjunction with the accompanying drawings, in which:

Fig. 1 is a cross-sectional view showing the structure of an element of a read-only semiconductor memory device according to a first embodiment of the present invention;

Fig. 2 is a pattern plan view of the read-only semiconductor memory device according to the first embodiment;

Fig. 3 is an equivalent circuit diagram of the read-only semiconductor memory device according to the first embodiment;

Fig. 4 is a cross-sectional view showing the structure of an element of a read-only semiconductor memory device according to a second embodiment of the present invention;

Fig. 5 is a cross-sectional view showing the structure of an element of a read-only semiconductor memory device according to a third embodiment of the present invention;

Fig. 6 is a pattern plan view showing the read-only semiconductor memory device according to the third embodiment; and

Fig. 7 is a block diagram showing a semiconductor device which is applied to the present invention.

A read-only semiconductor memory device according to the present invention comprises a plurality of memory cell transistor groups each having at least two memory cell transistors of MOS (metal oxide semiconductor) type are connected in series and a wiring layer for short-circuiting the source and drain of at least one of the MOS type memory cell transistors.

In the read-only semiconductor memory device, even after the electrodes of the memory cell transistors are formed, if the source and drain of a desired memory cell transistor is shortened using a metal wiring layer, the operation of the memory cell transistor can be made equal to that of a depletion type transistor. In other words, data can be programmed even after the electrodes of the memory cell transistors are formed.

Embodiments of the present invention will be described in detail.

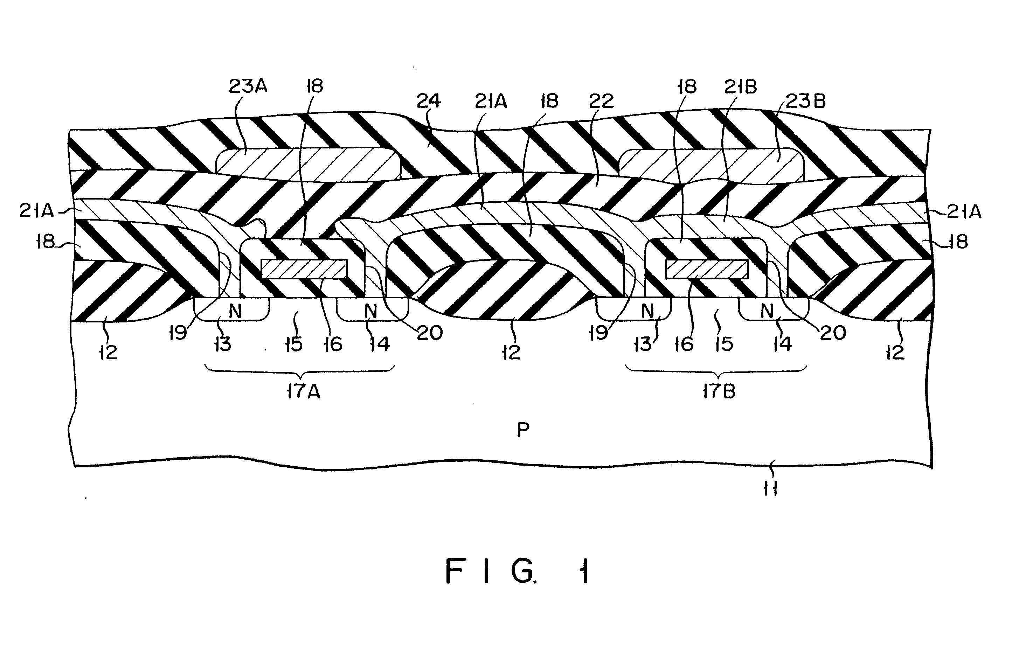

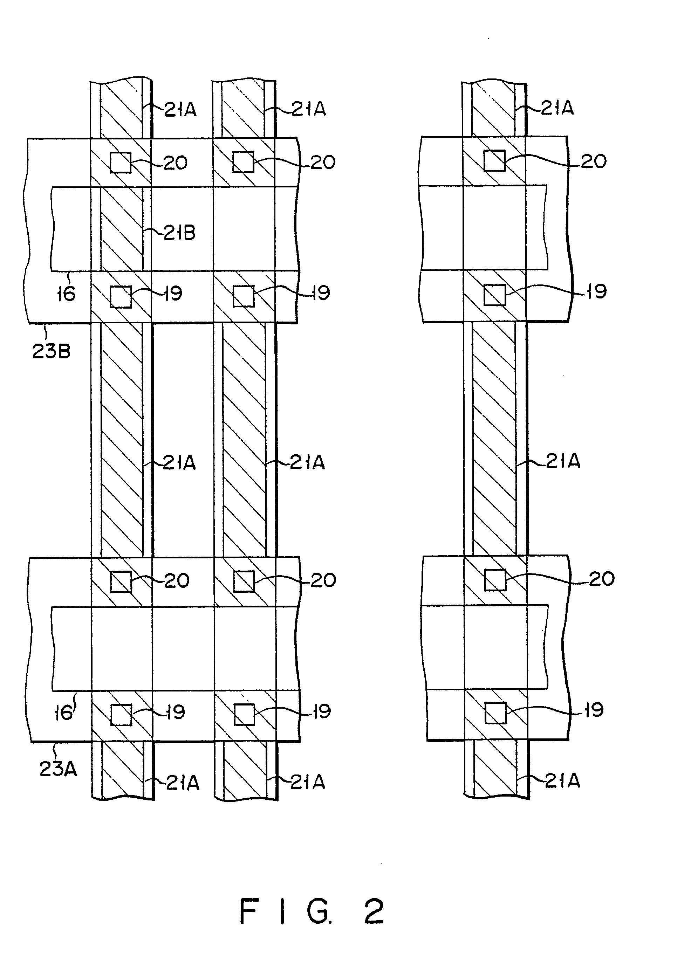

Fig. 1 is a cross-sectional view showing the structure of a read-only semiconductor memory device according to a first embodiment of the present invention. Fig. 2 is a pattern plan view of the device shown in Fig. 1.

In Fig. 1, a plurality of element regions is formed from a field oxide film 12 formed on a P-type semiconductor substrate 11. A source 13 and a drain 14, serving as N-type diffusion layers, and a P-type channel 15 are formed in the element regions. A gate electrode 16 constituted of a polysilicon layer is formed above the channel 15. Figs. 1 and 2 thus show two enhancement type memory cell transistors only.

An insulating oxide film 18 is deposited on the entire surface. Contact holes 19 and 20 are formed in the insulating oxide film 18 to contact the source 13 and drain 14 of the memory cell transistor. A first aluminum layer is deposited on the insulating oxide film 18 including inner portions of the contact holes 19 and 20 and then patterned to have a shape corresponding to data to be programmed. A wiring layer is thus formed. The wiring layer includes a wiring layer 21A for connecting adjacent memory cell transistors and a wiring layer 21B for short-circuiting the source 13 and the drain 14 to operate the memory cell transistors each having the P-type channel 15 and formed as an enhancement type in the same manner as a depletion type transistor does. In the first embodiment, the wiring layer 21B is formed in a memory cell transistor 17B.

An interlayer insulating film 22 is formed on the wiring layers 21A and 21B. Wiring layers 23A, 23B, each layer is of constituted of a second aluminum layer are formed on the interlayer insulating film 22. The wiring layers 23A, 23B extend in parallel to the gate electrode 16 of each memory cell transistor and contact the gate electrode 16 at a predetermined position not shown. The wiring layers 23A, 23B serve to reduce the wiring resistance of the gate electrode 16. A passivation film 24 is formed so as to cover the wiring layers 23A, 23B.

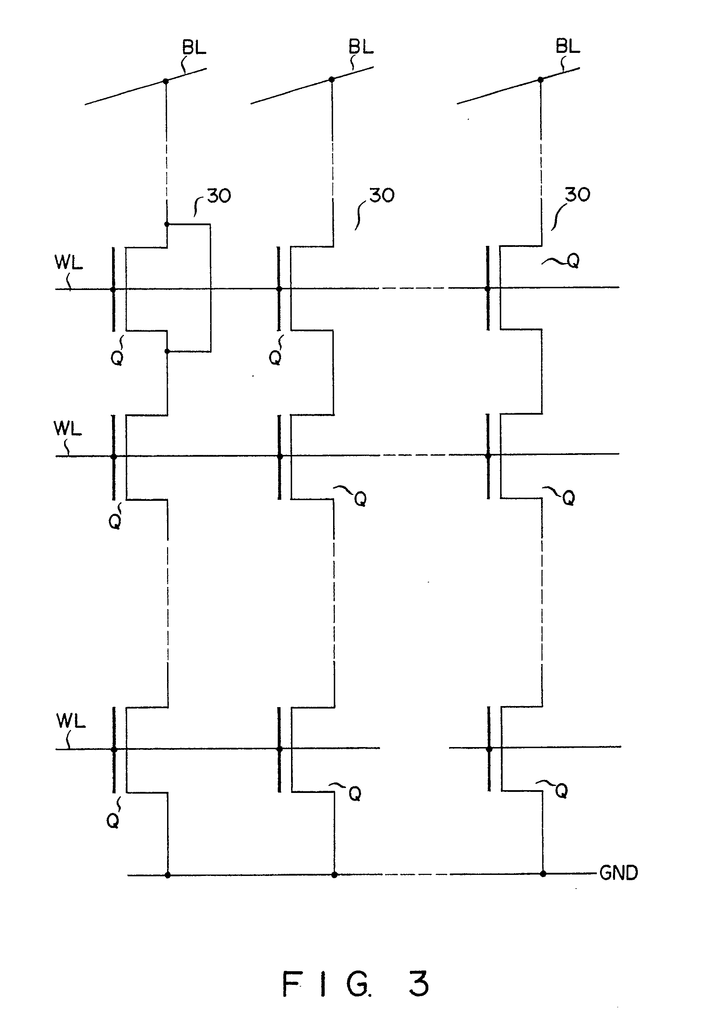

A plurality of memory cell transistor groups 30 as shown in Fig. 3, is formed in the semiconductor memory device shown in Figs. 1 and 2. In each of the memory cell transistor groups 30, plural enhancement type memory cell transistors Q are connected in series, and one terminal of each of the memory cell transistors is connected to a corresponding bit line BL and the other terminal thereof is connected to ground GND. The gate electrode common to the memory cell transistors Q is connected to word lines WL. The memory cell transistor groups 30 thus constitute a NAND-type mask ROM.

Although the memory cell transistor whose source and drain are short-circuited by the wiring layer 21B is originally of an enhancement type, it is operated like a depletion type transistor. A memory cell transistor whose source and drain are not short-circuited, is rendered conductive only when a high potential is applied to the gate electrode (word line WL). The memory cell transistor whose source and drain are short-circuited is always rendered conductive in spite of the potential of the gate electrode (word line WL).

In the semiconductor memory device according to the first embodiment, the memory cell transistors are connected in series to one another, and the source and drain of a specific one of the memory cell transistors are short-circuited by a wiring layer made of aluminum in accordance with data to be programmed when the wiring layer is formed. In a conventional semiconductor memory device, an enhancement type channel cannot be changed to a depletion type channel after a gate electrode is formed. It is thus impossible to change program data after formation of the gate electrode. In the semiconductor memory device of the first embodiment, however, since the source and drain are short-circuited by the wiring layer after the enhancement type memory cell transistor is formed, the memory cell transistor can be operated as if it were of a depletion type and, in other words, data can be changed. Since data can be changed, a semi-finished chip need not be given up and a development cost can be lowered.

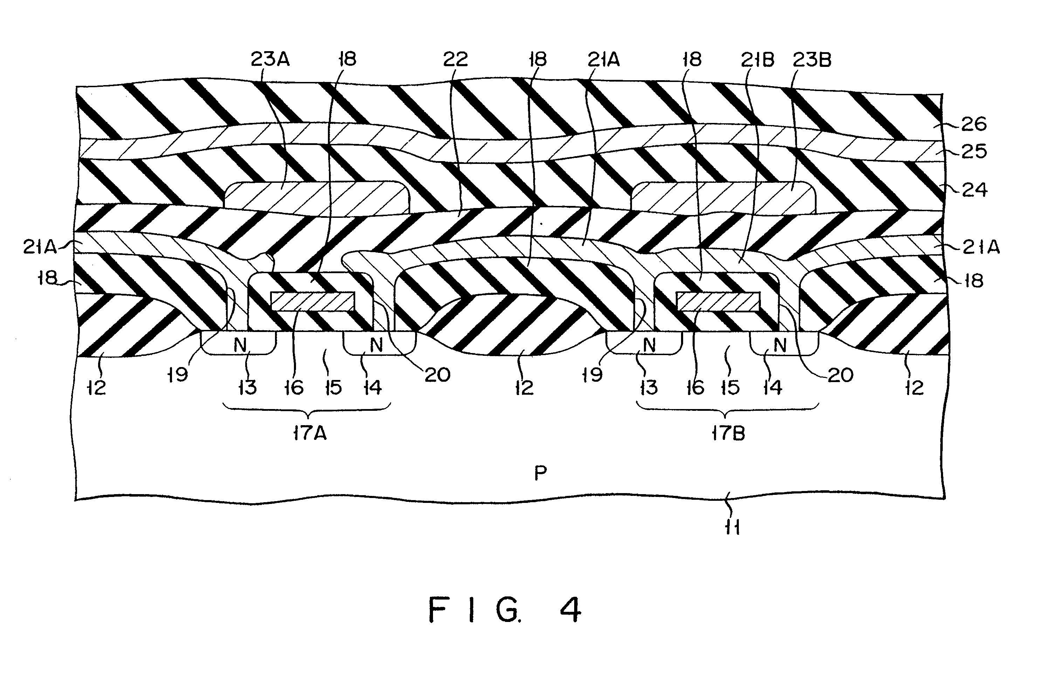

A second embodiment of the present invention will be next described with reference to Fig. 4. The descriptions of the elements denoted by the same numerals as those in Fig. 1 are omitted.

The semiconductor memory device of the second embodiment differs from that of the first embodiment in that a wiring layer 25 constituted of a third aluminum layer is formed on the passivation film 24. In the second embodiment, the wiring layer 25 is used as the bit line BL.

In the second embodiment, a NOR-type mask ROM (not shown) is provided in addition to the NAND-type mask ROM. The wiring layer 25 forms a bit line for connecting a data output node of the NAND-type mask ROM and that of the NOR-type mask ROM.

A passivation film 26 is formed so as to cover the wiring layer 25.

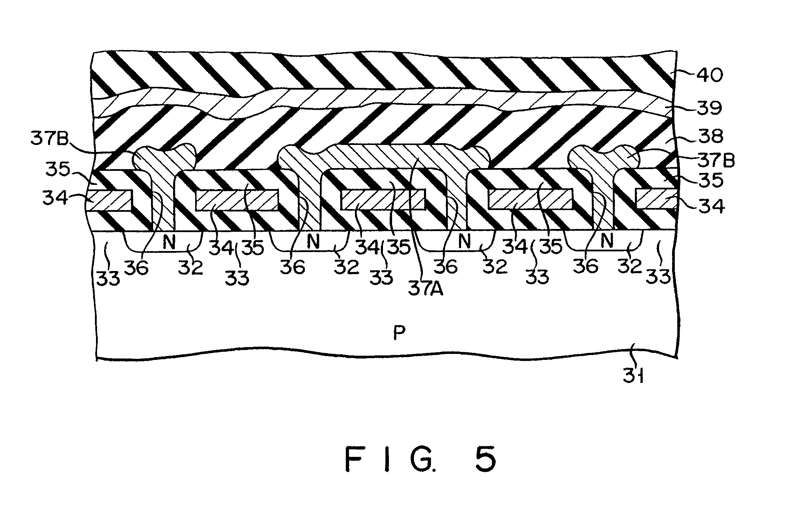

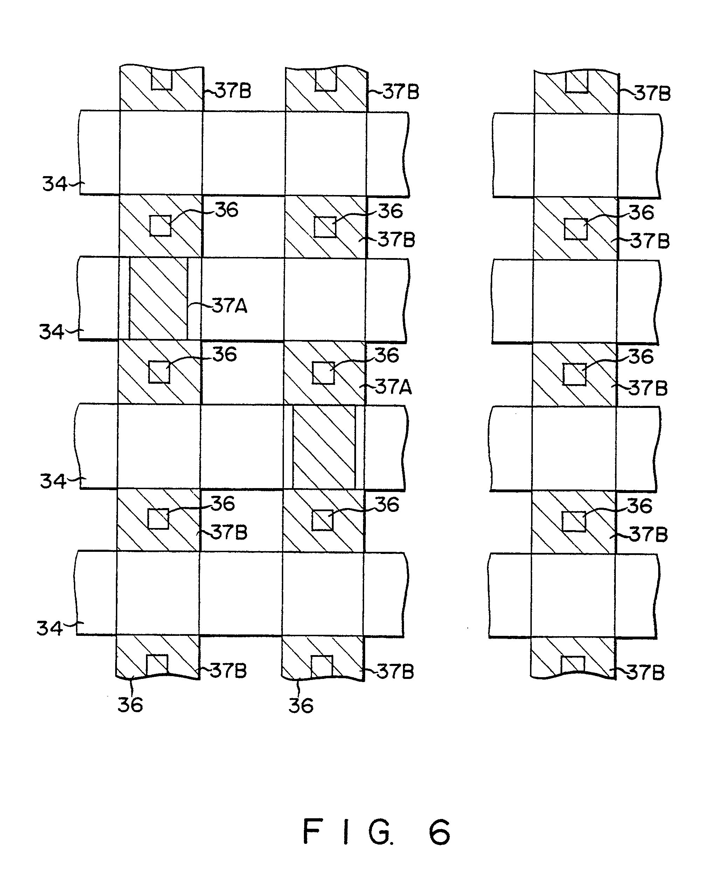

A third embodiment of the present invention will be described with Figs. 5 and 6.

In the semiconductor memory device according to the third embodiment, all memory cell transistors of one memory cell transistor group are formed in a single element region without separating the memory cell transistors by a field oxide film, as in the device shown in Fig. 1. No field oxide films are therefore formed between the memory cell transistors of one memory cell transistor group.

A source/drain mutual region 32 constituted of an N-type diffusion layer and serving as the source and drain of a MOS type memory cell transistor and a P-type channel 33 are formed in a P-type semiconductor substrate 31. A gate electrode is formed of polysilicon above the channel 33.

An insulating oxide film 35 is deposited on the entire surface of the resultant structure, and a contact hole 36 is formed in the insulating oxide film 35 to be brought into contact with the source/drain mutual region 32. A first aluminum layer is deposited on the insulating oxide film 35 including an inner portion of the contact hole 36 and then patterned to have a shape corresponding to data to be programmed. A wiring layer is thus formed. The wiring layer includes a wiring layer 37A formed so as to cover adjacent two contact holes 36 and a wiring layer 37B formed so as to fill in only one contact hole 36.

An interlayer insulating film 38 is formed on the wiring layers 37A and 37B, and another wiring layer 39 is formed of a second aluminum on the interlayer insulating film 38. The wiring layer 39 forms the same bit line as used in the second embodiment shown in Fig. 4. A passivation film 40 is then formed so as to cover the wiring layer 39.

The equivalent circuit of the semiconductor memory device according to the third embodiment is the same as that shown in Fig. 3, and comprises a plurality of memory cell transistor groups 30 each including a plurality of enhancement type memory cell transistors Q connected in series. In the third embodiment, however, the memory cells are not connected in series by the wiring layer but are formed by constituting the source and drain of a common diffusion layer.

The memory device of the present invention can be used as follows.

When a user cannot determine part of data, a channel is so formed that all memory cell transistors of the undetermined part are of an enhancement type, and a wafer having an insulating oxide film deposited so as to cover the gate electrode of the transistor is prepared beforehand. If the source and drain of a desired memory cell transistor is short-circuited when a user's program is determined, data can be programmed.

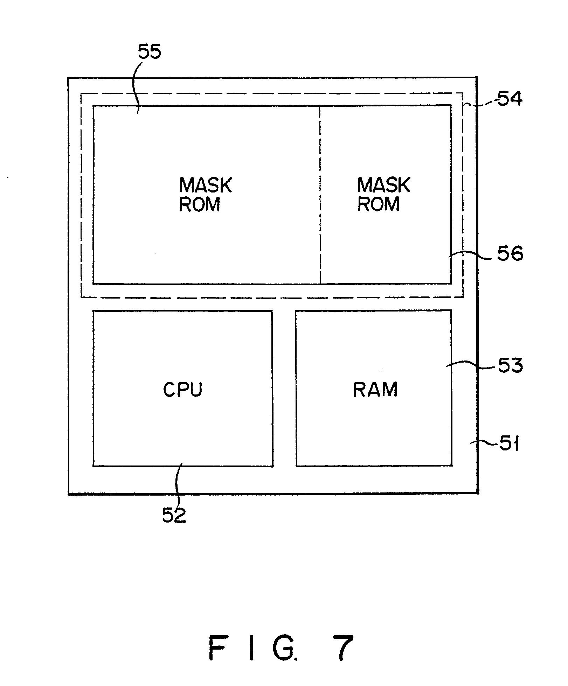

Fig. 7 is a block diagram showing an arrangement of a one-chip microcomputer which is applied to the present invention. In this microcomputer, a central processing unit (CPU) 52, a random access memory (RAM) 53 and a mask ROM 54 are formed on a semiconductor chip 51.

When data to be written in the mask ROM 54 includes undetermined data which has been determined is written therein by selectively forming an enhancement type transistor and a depletion type transistor in a first mask ROM region 55. The undetermined data can be written if an enhancement type transistor is previously formed in a second mask ROM region 56 and, when the data is determined, the source and drain of a desired memory cell transistor are short-circuited or a region common to the source and drain is short-circuited.

This arrangement enables a wafer to be fabricated before a user determines data and shortens the time from when the user determines the data and to when the user obtains a finished product.

Furthermore, all enhancement type memory cell transistors are formed in the mask ROM 54, and a desired one of the transistors can be changed to a depletion type transistor by shortcircuiting the source and drain of the transistor or short-circuiting a region common to the source and drain when all data is determined.

Reference signs in the claims are intended for better understanding and shall not limit the scope.

## Claims

1. A read-only semiconductor memory device comprising:

    a memory cell group (30) including at least two series-connected memory cells each constituted of a MOS transistor (Q) having a source and a drain; and

    a first wiring layer (21B, 37A) for short-circuiting a source and a drain of a specific one of the memory cells of said memory cell group in accordance with program data.

2. The read-only semiconductor memory device according to claim 1, characterized in that said memory cells of said memory cell group are connected in series by a second wiring layer (21A).

3. The read-only semiconductor memory device according to claim 2, characterized in that said first and second wiring layers are formed of a metal wiring layer.

4. The read-only semiconductor memory device according to claim 1, characterized in that said memory cells are connected in series by forming sources and drains of two memory cells of a common diffusion layer (32).

5. The read-only semiconductor memory device according to claim 1, characterized in that each of said memory cells of said memory cell group includes an enhancement type MOS transistor.

6. A read-only semiconductor memory device characterized by further comprising:
    a semiconductor substrate (31) of a first conductivity type;
    a plurality of diffusion layers (32) of a second conductivity type, formed in said semiconductor substrate at predetermined intervals;
    a plurality of gate electrodes (34) each formed so as to extend over adjacent two diffusion layers;
    an insulating layer (35) formed on said plurality of gate electrodes; and
    a wiring layer (37A) formed of a metal wiring layer formed on said insulating layer, for connecting said adjacent two diffusion layers in accordance with program data.

F I G. 1

# F I G. 2

F I G. 3

F I G. 4

EP 0 447 976 A1

F I G. 5

F I G. 6

55

54

MASK
ROM

MASK
ROM

56

CPU

RAM

53

51

52

F I G. 7

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | PATENT ABSTRACTS OF JAPAN, vol. 9, no. 118 (E-316)[1841], 23rd May 1985; & JP-A-60 9157 (FUJITSU K.K.) 18-01-1985 * Abstract; figures * | 1,4,6 | H 01 L 27/112 |
| | – – – | | |
| X | GB-A-2 102 623 (TOKYO SHIBAURA DENKI K.K.) * Claims 1,4; page 3, line 112 - page 4, line 47; page 5, lines 25-115; figures 8,10A-10E * | 1,4-6 | |
| | – – – | | |
| X | PATENT ABSTRACTS OF JAPAN, vol. 8, no. 235 (E-275)[1672], 27th October 1984; & JP-A-59 117 158 (NIHON DENKI AISHII MAIKON SYSTEM K.K.) 06-07-1984 * Abstract; figures * | 1-3 | |
| | – – – – – | | |

TECHNICAL FIELDS SEARCHED (Int. Cl.5)

H 01 L 27
G 11 C 17

The present search report has been drawn up for all claims

| Place of search | Date of completion of search | Examiner |
|---|---|---|
| The Hague | 27 June 91 | FRANSEN L.J.L. |